# EUROPÄISCHE PATENTSCHRIFT

(11) **EP 3 141 960 B1**
(45) Veröffentlichungstag und Bekanntmachung des Hinweises auf die Patenterteilung: **09.10.2019**
(21) Anmeldenummer: 16001979.0
(22) Anmeldetag: 12.09.2016
(51) Int. Cl.: G03F 7/20, F24F 3/16, E04B 5/48, H01L 21/67, E04B 5/43, E04F 15/02, E04H 5/02

(54) **FERTIGUNGSANLAGE ZUR HERSTELLUNG VON INTEGRIERTEN SCHALTKREISEN AUS HALBLEITER-WAFERN SOWIE WAFFELELEMENT FÜR EINE FERTIGUNGSANLAGE**
PRODUCTION PLANT FOR PRODUCING INTEGRATED CIRCUITS FROM SEMICONDUCTOR WAFERS AND WAFFLE ELEMENT FOR A PRODUCTION PLANT
INSTALLATION DE FABRICATION DE CIRCUITS INTÉGRÉS DE COMMUTATION À PARTIR DE WAFERS SEMI-CONDUCTEURS ET ÉLÉMENT ALVÉOLÉ POUR UNE INSTALLATION DE FABRICATION

(30) Priorität: 14.09.2015 DE 102015012053
(43) Veröffentlichungstag der Anmeldung: 15.03.2017
(73) Patentinhaber: M+W Group GmbH, 70499 Stuttgart (DE)
(72) Erfinder: Schneider, Hartmut, 70193 Stuttgart (DE); Eberle, Freyja, 71686 Remseck-Aldingen (DE); Köhler, Steffen, 71665 Vaihingen/Enz (DE); Csátary, Peter, 71254 Ditzingen (DE); Blaschitz, Herbert, 71229 Leonberg (DE)
(74) Vertreter: Kohl, Karl-Heinz

(56) Entgegenhaltungen:
- WO-A2-2015/044182
- DE-A1-102008 014 832
- DE-A1-102013 223 935
- US-A- 5 058 491
- US-A1- 2002 092 249

## Beschreibung

Die Erfindung betrifft ein Waffelelement für eine Fertigungsanlage nach dem Oberbegriff des Anspruches 1 und eine Fertigungsanlage zur Herstellung von integrierten Schaltkreisen (Chips) auf Wafern nach dem Oberbegriff des Anspruches 5.

Bei der Herstellung von Chips werden Wafer eingesetzt, die mit EUV-Strahlung (Extreme Ultra Violett) belichtet werden. Diese EUV-Strahlung hat nur eine sehr geringe Wellenlänge, so dass Chips mit sehr kleinen Strukturbreiten gefertigt werden können. Die EUV-Strahlung wird bei der Erzeugung von Plasmen frei, die durch Fokussierung von Laserstrahlung auf Zinntröpfchen entstehen Diese EUV-Strahlung wird den Lithografie-Maschinen zugeführt, mit denen die Wafer bei der Herstellung der Chips belichtet werden. Die Lithografie-Maschinen befinden sich in einem Fabrikationsgebäude.

Bei einer solchen Fertigungsanlage (WO 2015/044182 A2) wird die EUV-Strahlung vom Gebäude oder Gebäudeabschnitt aus über eine Strahlführung dem Fabrikationsgebäude zugeführt. Von der Strahlführung zweigt im Bereich des Fabrikationsgebäudes unter einem stumpfen Winkel eine Zuleitung ab, über die ein Teil der EUV-Strahlung der Lithografie-Maschine zugeführt wird.

Bei einer anderen bekannten Fertigungsanlage (DE 10 2013 223 935 A1) wird ebenfalls eine EUV-Strahlung unter einem stumpfen Winkel zu mehreren Lithografie-Maschinen geführt. Die Lichtquelle, welche die EUV-Strahlung imitiert, ist als Freie-Elektronen-Laser ausgebildet.

Aus der DE 10 2008 014 832 A1 ist es bekannt, eine Beleuchtungsstrahlung unter einem spitzen Winkel durch eine Gebäudedecke einer Projektions-Belichtungsanlage zuzuführen.

Es sind Waffelelemente bekannt (US 5 058 491 A, US 2002/0092249 A1), die mit einem rechteckigen Durchlass versehen sind.

Der Erfindung liegt die Aufgabe zugrunde, das gattungsgemäße Waffelelement sowie die gattungsgemäße Fertigungsanlage so auszubilden, dass die Zuführung der EUV-Strahlung zur Lithografie-Maschine kostengünstig und einfach gestaltet werden kann.

Diese Aufgabe wird beim gattungsgemäßen Waffelelement erfindungsgemäß mit den kennzeichnenden Merkmalen des Anspruches 1 und bei der gattungsgemäßen Fertigungsanlage erfindungsgemäß mit den Merkmalen des Anspruches 5 gelöst.

Das erfindungsgemäße Waffelelement ist vorzugsweise mit mehreren Durchlässen für die Zuleitung versehen. Die Zuleitung kann dadurch sehr einfach durch den gelochten Boden von unten zur Lithografie-Maschine herangeführt werden, die auf dem gelochten Boden steht. Hat das Waffelelement in bevorzugter Weise mehrere Durchlässe, dann kann die Zuleitung durch den jeweils am besten geeigneten Durchlass in den Reinraum geführt werden.

Das Waffelelement weist viereckigen Umriss auf, so dass sich der gelochte Boden sehr einfach aus den Waffelelementen zusammenstellen lässt. Die eine Seite des rechteckigen Durchlasses schließt mit der einen Seite des viereckigen Waffelelementes, in Draufsicht auf das Waffelelement gesehen, einen spitzen Winkel ein.

Da die Zuleitung unter einem stumpfen Winkel von der Strahlführung abzweigt, ist der Durchlass daher so vorgesehen, dass er unter einem spitzen Winkel schräg zur Mittelebene des Waffelelementes liegt. Da der Durchlass rechteckigen Umriss aufweist, kann der Durchlass so im Waffelelement vorgesehen sein, dass sich die Zuleitung durch das Waffelelement schräg hindurch erstrecken kann.

Bevorzugt befindet sich der Durchlass mittig im Waffelelement.

Bei einer bevorzugten Ausführungsform weist das Waffelelement wenigstens zwei nebeneinanderliegende Abschnitte auf, von denen der eine Abschnitt den Durchlass für die Zuleitung und der andere Abschnitt Durchtrittsöffnungen für Reinluft aufweist. Das Waffelelement ist in diesem Falle mit zwei unterschiedlichen Durchlässen versehen. Es ist darum in vorteilhafter Weise nicht notwendig, für die unterschiedlichen Durchlässe unterschiedliche Waffelelemente zu verwenden.

Die Abschnitte des Waffelelementes weisen vorteilhaft gleiche Umrissform und vorteilhaft auch gleiche Dicke aufund entsprechen der Last- und Schwingungsspezifikation der übrigen Waffelelemente.

Bei der erfindungsgemäßen Fertigungsanlage befindet sich der die EUV-Strahlung erzeugende Strahlungserzeuger in einem vom Fabrikationsgebäude getrennten Gebäude oder Gebäudeabschnitt. Die erzeugte EUV-Strahlung wird über wenigstens eine Strahlführung dem Fabrikationsgebäude zugeführt. Um die EUV-Strahlung an die Lithografie-Maschine innerhalb des Fabrikationsgebäudes heranzuführen, zweigt von der Strahlführung wenigstens eine Zuleitung ab, die zur Lithografie-Maschine unter einem stumpfen Winkel verläuft. Da sich der Strahlungserzeuger nicht im Fabrikationsgebäude befindet, muss bei seinem Bau nicht auf Besonderheiten des Fabrikationsgebäudes Rücksicht genommen werden. Darum kann das/der den Strahlungserzeuger enthaltende Gebäude/Gebäudeabschnitt optimal am vorhandenen Platz innerhalb des Geländes der Fertigungsanlage errichtet werden. Die Strahlführung ist eine Vakuumröhre, in der die EUV-Strahlung propagiert wird. Das Vakuum stellt sicher, dass die EUV-Strahlen nicht oder nur unwesentlich absorbiert werden. Die Auskoppelung der EUV-Strahlung aus der Strahlführung in die Zuleitung erfolgt in einem stumpfen Winkel durch optische Strahlteiler.

Die Strahlführung befindet sich im Bereich unterhalb der Lithografie-Maschine. Die Zuleitung verläuft durch einen Durchlass in einem gelochten Boden des Reinraumes. Der gelochte Boden des Reinraumes wird durch die Waffelelemente gebildet. Sie bilden vorgefertigte Bauteile, die zur Bildung des gelochten Bodens aneinander gesetzt und fest miteinander verbunden werden. Der Durchlass hat rechteckigen Umriss und schließt mit einer Mittelebene des Waffelelementes, in Draufsicht auf das Waffelelement gesehen, einen spitzen Winkel ein. Aufgrund der Rechteckausbildung des Durchlasses kann dieser so groß gewählt werden, dass je nach Größe die Zuleitung schräg durch den Durchlass hindurchgeführt werden kann.

Die Lithografie-Maschine ist vorteilhaft in einem Reinraum des mehrgeschossigen Fabrikationsgebäudes untergebracht, so dass die Belichtung der Wafer zuverlässig durchgeführt werden kann. Die Geschosse oberhalb und/oder unterhalb des Reinraumes werden vorteilhaft für die Zuführung und Ableitung von reiner Luft sowie für die Medienversorgung und -entsorgung genutzt. Der Boden zwischen Reinraum und darunter liegendem Geschoss ist als Waffelboden ausgeführt.

Eine einfache Zuführung der EUV-Strahlung ergibt sich, wenn die Strahlführung in vorteilhafter Weise im Bereich unterhalb der Lithografie-Maschine im Fabrikationsgebäude verläuft. Dann ist der Bereich oberhalb der Lithografie-Maschine frei für beispielsweise Transporteinrichtungen, mit denen die Lithografie-Maschinenteile und Material transportiert werden können.

Im Reinraum befinden sich vorteilhaft mehrere Lithografie-Maschinen, die bevorzugt in einer Reihe nebeneinander angeordnet sind.

Wenn die Fertigungsanlage neu gebaut wird, bietet es sich an, die Strahlführung so vorzusehen, dass sie unterhalb der Bodenplatte des Fertigungsgebäudes verläuft. Dann kann die Strahlführung im Hinblick auf bautechnische Maßnahmen, Geländeerfordernisse und dergleichen optimal verlegt werden. Der Innenraum des Fabrikationsgebäudes ist dann frei von der Strahlführung, so dass das Fabrikationsgebäude optimal genutzt werden kann.

Besteht das Fabrikationsgebäude bereits, dann ist es vorteilhaft, wenn die Strahlführung in ein Geschoss des Fabrikationsgebäudes unterhalb oder oberhalb des Reinraumes verlegt wird. Von hier aus lassen sich dann die entsprechenden Zuleitungen leicht zu der oder den Lithografie-Maschine(n) führen.

Um die von der Strahlführung und/oder der Zuleitung und ihren optischen Elementen zugeführte EUV-Strahlung nicht durch Vibrationen zu beeinträchtigen, wird die Strahlführung bevorzugt im Bereich eines Personalzuganges an das Fabrikationsgebäude herangeführt. Im Bereich des Personalzuganges sind Erschütterungen, die sich nachteilig auf die EUV-Strahlung in der Strahlführung auswirken würden, nicht oder nur in vernachlässigbarer Weise gegeben.

Vorteilhaft befindet sich dann der Materialzugang an der dem Personalzugang gegenüberliegenden Seite des Fabrikationsgebäudes. Im Bereich des Materialzuganges treten in der Regel größere Schwingungen auf, die beispielsweise durch Transportfahrzeuge und dergleichen hervorgerufen werden, sich aber wegen des großen Abstandes von der Strahlführung nicht nachteilig auf die EUV-Strahlung auswirken.

Die Erfindung wird durch die Ansprüche definiert.

Die Erfindung wird anhand einiger in den Zeichnungen dargestellter Ausführungsformen näher erläutert. Es zeigen
- Fig. 1: in schematischer Darstellung und in Draufsicht den Lageplan einer erfindungsgemäßen Fertigungsanlage zur Herstellung von integrierten Schaltkreisen auf Halbleiter- Wafern,
- Fig. 2 bis 5: jeweils in schematischer Darstellung und in Seitenansicht verschiedene Ausführungsformen von erfindungsgemäßen Fertigungsanlagen,
- Fig. 6: in Stirnansicht die Ausführungsform gemäß Fig. 2,
- Fig. 7: eine Draufsicht auf einen aus Waffelelementen bestehenden Boden der erfindungsgemäßen Fertigungsanlage,
- Fig. 8: in vergrößerter Darstellung und in Draufsicht ein Waffelelement,
- Fig. 9: in schematischer Darstellung die Durchführung einer Strahlführung durch das Waffelelement gemäß Fig. 8.

Bei der Herstellung von integrierten Schaltkreisen oder Bauelementen (Chips) auf Wafern werden Lithografie-Maschinen eingesetzt, mit denen die Wafer in bekannter Weise belichtet werden.

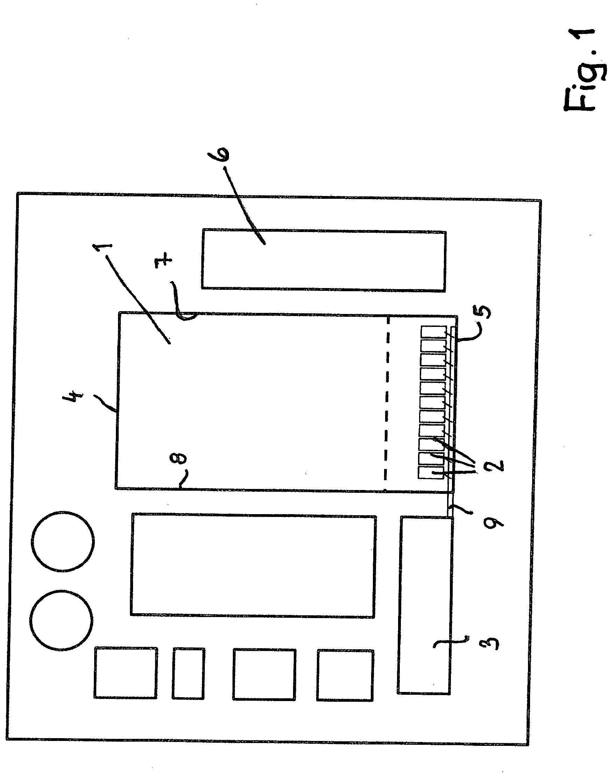

Fig. 1 zeigt in schematischer Darstellung eine übliche Anlage zur Herstellung von Chips auf Wafern. Die Anlage hat ein Gebäude 1, in dem die Chips hergestellt werden. Hierfür werden Wafer verwendet, die in bekannter Weise auf Lithografie-Maschinen 2 belichtet werden. Da dieses Verfahren bekannt ist, wird es nachfolgend nur kurz beschrieben. Auf den Wafer wird ein Fotolack aufgetragen, der anschließend belichtet wird. Nach dem Belichtungsvorgang wird der Wafer entwickelt. Zur Belichtung des Wafers wird eine Synchrotronstrahlung verwendet, die mittels eines FEL (Freier Elektronenlaser) erzeugt wird. Dieser Laser ist so ausgebildet, dass er Strahlung im Röntgenbereich erzeugt. Solche Laser werden als FEL oder als Röntgenlaser bezeichnet. Mit ihm kann extrem energiereiches Laserlicht mit Wellenlängen von 0,05 bis ca. 30 nm erzeugt werden. Mit einer solchen Strahlung können auf den Wafern sehr feine und enge Strukturen durch die Belichtung erzeugt werden.

Der zur Erzeugung dieser Röntgenstrahlung erforderliche Röntgenlaser FEL ist in einem Gebäude 3 untergebracht, das sich neben dem Gebäude 1 befindet.

Das Fabrikationsgebäude 1 ist bevorzugt so ausgebildet, dass eine Materialzugangsseite 4 von einer Personalzugangsseite 5 räumlich getrennt ist. Im dargestellten bevorzugten Ausführungsbeispiel hat das Fertigungsgebäude 1 etwa rechteckigen Umriss. In diesem Falle befinden sich die Materialzugangsseite 4 und die Personalzugangsseite 5 an den beiden Schmalseiten des Fabrikationsgebäudes 1. Das Personal selbst wird in einem Verwaltungsgebäude 6 untergebracht, das sich benachbart zu einer Längsseite 7 des Fabrikationsgebäudes 1 befindet.

Benachbart zur gegenüberliegenden Längsseite 8 des Fabrikationsgebäudes 1 befinden sich beispielhaft Versorgungsgebäude sowie Lagergebäude, die in Fig. 1 nicht näher bezeichnet sind.

Da sich das FEL-Gebäude 3 neben dem Fabrikationsgebäude 1 befindet, muss die vom Röntgenstrahllaser erzeugte Röntgenstrahlung über wenigstens eine Strahlführung 9 den Lithografie-Maschinen 2 zugeführt werden. In Fig. 1 ist die Strahlführung 9 schematisch dargestellt.

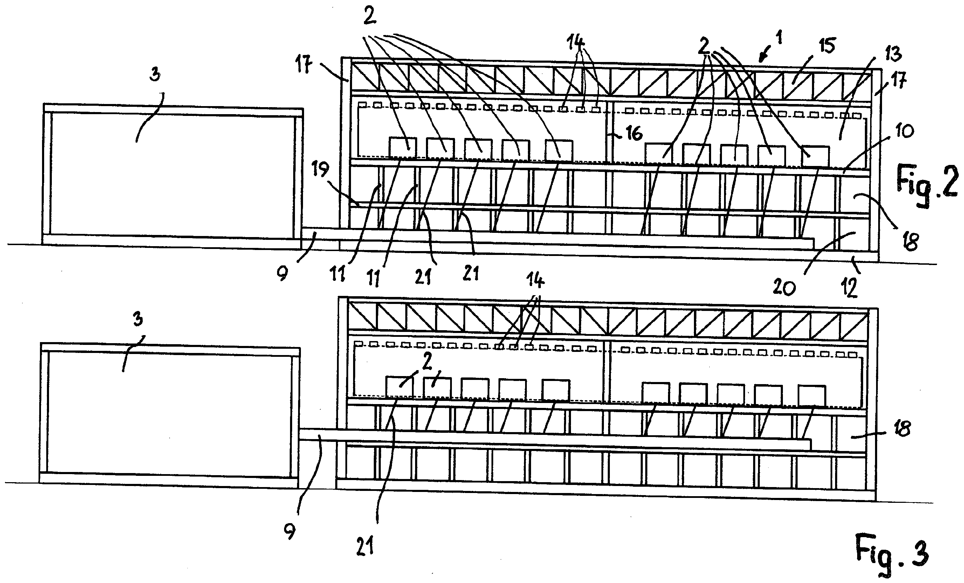

Fig. 2 zeigt eine beispielhafte Ausgestaltung des Fabrikationsgebäudes 1. Die Lithografie-Maschinen 2 befinden sich auf einem Boden 10, der mit Stützen 11 auf dem Fundament 12 abgestützt ist. Die Lithografie-Maschinen 2 befinden sich in einem Reinraum 13, der den für die Belichtung der Wafer vorgeschriebenen Reinraumbedingungen genügt. Der Reinraum 13 ist im Deckenbereich durch Filter-Ventilator-Einheiten 14 begrenzt, die in Fig. 2 nur schematisch dargestellt sind. Die Filter-Ventilator-Einheiten 14 sind in bekannter Weise ausgebildet und leiten die Reinluft nach unten in den Reinraum 13. Der Boden 10 des Reinraumes 13 ist mit Durchtrittsöffnungen für die Reinluft versehen, die in bekannter Weise nach dem Durchtritt durch die Öffnungen des Bodens 10 zu den Filter-Ventilator-Einheiten 14 zurückgeführt wird. Hierbei kann die Reinluft konditioniert sowie gegebenenfalls auch erwärmt werden. Diese Behandlung der Reinluft ist bekannt und wird darum auch nicht näher beschrieben.

Oberhalb der Filter-Ventilator-Einheiten 14 befindet sich ein Tragwerk 15, längs dem beispielsweise ein Transportkran oder dergleichen verfahrbar ist, mit dem beispielsweise die Lithografie-Maschinen 2 transportiert werden können. Das Tragwerk 15 ist mit entsprechenden Laufschienen versehen, längs denen der Kran verfahren werden kann. Das Tragwerk 15 sowie die darunter angeordneten Filter-Ventilator-Einheiten 14 sind über Stützen 16 und Wände 17 in geeigneter Weise auf dem Fundament 12 abgestützt.

Unterhalb des Bodens 10 des Reinraums 13 befindet sich ein Untergeschoss 18 mit einem Boden 19. Er trennt das Untergeschoss 18 von einem darunter befindlichen weiteren Untergeschoss 20, das als Boden das Fundament 12 oder einen zusätzlichen Boden aufweisen kann. Innerhalb des Untergeschosses 18 befinden sich die Stützen 11, die über die Fläche des Bodens 19 vorteilhaft gleichmäßig verteilt angeordnet sind und den Boden 10 des Reinraumes 13 abstützen. Die Stützen 11 erstrecken sich vorteilhaft auch durch das Untergeschoss 20 und stützen dann den Boden 19 auf dem Fundament 12 ab.

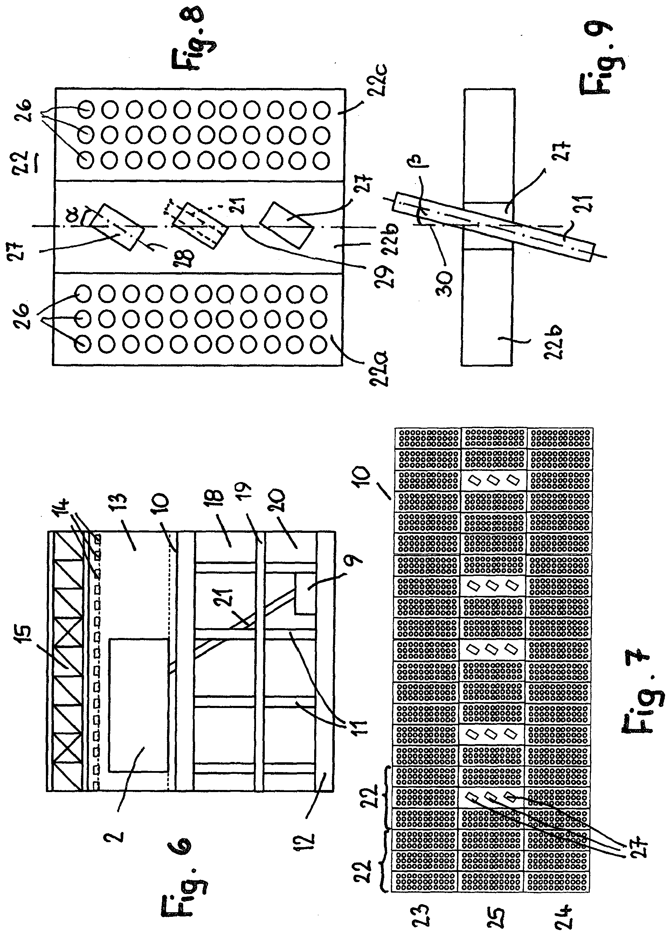

Da sich der Röntgenlaser im Gebäude 3 befindet, muss die von ihm erzeugte Röntgenstrahlung den Lithografie-Maschinen 2 im Fabrikationsgebäude 1 zugeführt werden. Die Anlage zur Erzeugung der Röntgenstrahlung hat große Abmessungen, beispielsweise eine Längenausdehnung von etwa 100 m. Dementsprechend ist auch das Gebäude 3, in dem diese Strahlungserzeugungsquelle untergebracht ist, entsprechend groß. Die vom FEL erzeugte Röntgenstrahlung wird über die wenigstens eine Strahlführung 9 aus dem Gebäude 3 herausgeführt. Die Strahlführung 9 ist in bekannter Weise eine Vakuumröhre, in der die Röntgenstrahlung propagiert wird. Bei der Ausführungsform gemäß Fig. 2 ist die Strahlführung 9 in das untere Untergeschoss 20 geführt. Hierbei ist es zweckmäßig, wenn die Strahlführung 9 unmittelbar auf dem Fundament 12 oder einem zusätzlichen Boden des Untergeschosses 20 aufliegend befestigt ist. Wie aus Fig. 6 hervorgeht, ist die Strahlführung 9 so vorgesehen, dass sie mit ihrer einen Längsseite an den vertikalen Stützen 11 anliegt.

Innerhalb der Strahlführung 9 wird die Röntgenstrahlung in bekannter Weise durch Optiken in schräg aufwärts verlaufende Zuleitungen 21 ausgekoppelt, über welche der ausgekoppelte Anteil der Röntgenstrahlung den Lithografie-Maschinen 2 zugeführt wird. Für jede Belichtungsmaschine 2 ist jeweils eine Zuleitung 21 vorgesehen.

Die Zuleitungen 21 schließen an die Strahlführung 9 stumpfwinklig an (Fig.2).

Das zugeführte Röntgenlicht wird an der jeweiligen Maschine 2 in bekannter Weise wieder ausgekoppelt und zur Belichtung der Wafer in der Maschine 2 herangezogen.

Die Böden 10, 19 sind in noch zu beschreibender Weise mit Durchlässen versehen, durch welche die Zuleitungen 21 verlaufen.

Die Strahlführung 9 ist so lang, dass die im Reinraum 13 stehenden Maschinen 2 über die Zuleitungen 21 mit der notwendigen Röntgenstrahlung beliefert werden können. Da sich die Strahlführung 9 gerade erstreckt, ist es vorteilhaft, wenn die Maschinen 2 in einer Reihe mit Abstand nebeneinander im Reinraum 13 angeordnet sind. Dann ist eine einfache Strahlungsversorgung dieser Maschinen mittels der Zuleitungen 21 möglich.

Vorteilhaft ist die Strahlführung 9 so im Untergeschoss 20 positioniert, dass das Untergeschoss noch optimal für andere Zwecke genutzt werden kann. Aus diesem Grunde ist die Strahlführung 9 nahe der einen Schmalseite des Fabrikationsgebäudes 1 verlegt. Wie Fig. 6 zeigt, kann der Bereich links neben der Strahlführung 9 durchaus für andere Zwecke genutzt werden.

Bei der Ausführungsform gemäß Fig. 3 wird die Strahlführung 9 in das Untergeschoss 18 geführt. Dort kann die Strahlführung 9 in gleicher Weise positioniert werden wie im Untergeschoss 20 gemäß Fig. 2. Da die Strahlführung 9 einen kürzeren Abstand zu den Lithografie-Maschinen 2 hat, können die Zuleitungen 21 entsprechend kürzer gestaltet sein. Dies hat den Vorteil, dass eventuell auftretende Strahlungsverluste geringer gehalten werden können. Im Übrigen ist die Ausführungsform gemäß Fig. 3 gleich ausgebildet wie das Ausführungsbeispiel gemäß Fig. 2.

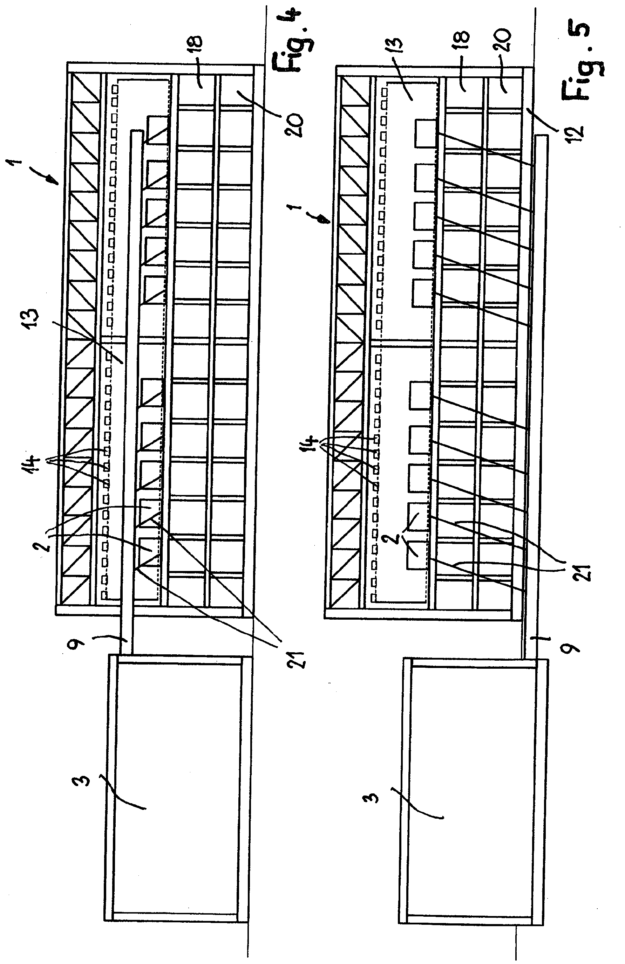

Während bei den Ausführungsformen gemäß den Fig. 2 und 3 die Zuleitungen 21 im Fabrikationsgebäude 1 von unten her an die Lithografie-Maschinen 2 herangeführt werden, erfolgt beim Ausführungsbeispiel gemäß der Fig. 4 die Zuführung der Röntgenstrahlen zu den Lithografie-Maschinen 2 von oben her. Die Strahlführung 9 ist so vorgesehen, dass sie im Bereich oberhalb der Lithografie-Maschinen 2 in den Reinraum 13 geführt wird. Zweckmäßig befindet sich die Strahlführung 9, die vom FEL-Gebäude 3 aus herausgeführt ist, nicht unmittelbar oberhalb der Maschinen 2, sondern entsprechend den vorigen Ausführungsbeispielen seitlich versetzt zu ihnen. Dadurch ist der Zugang zu den Maschinen 2 nicht beeinträchtigt. Die Zuleitungen 21 zweigen von der Strahlführung 9 schräg nach unten zu den einzelnen Maschinen 2 ab. Die Zuleitungen 21 zweigen entsprechend den vorigen Ausführungsformen stumpfwinklig von der Strahlführung 9 ab, senkrecht zur Strahlungsleitung gesehen (Fig. 4). Da sich die Strahlführung 9 in den Reinraum 13 erstreckt, können die Zuleitungen 21 kurz sein, was sich vorteilhaft auf eventuell entstehende Strahlungsverluste auswirkt.

Die Untergeschosse 18, 20 stehen bei dieser Ausführungsform vollständig für andere Aufgaben zur Verfügung.

Im Übrigen ist diese Ausführungsform gleich ausgebildet wie die vorigen Ausführungsbeispiele.

Fig. 5 zeigt die Möglichkeit, die Strahlführung 9 des FEL-Gebäudes 3 nicht in das Fabrikationsgebäude 1 zu verlegen, sondern in einem Bereich unterhalb des Fabrikationsgebäudes 1 vorzusehen. Die Strahlführung 9 verläuft unterhalb der Bodenplatte des Fundamentes 12. Diese Ausbildung ist dann von Vorteil, wenn das Fabrikationsgebäude 1 sowie das FEL-Gebäude 3 gleichzeitig errichtet werden. Die vorigen Ausführungsbeispiele sind dann von Vorteil, wenn das Fabrikationsgebäude 1 bereits besteht und die darin befindlichen Maschinen 2 nachträglich mit der Röntgenstrahlung versorgt werden sollen.

Die Zuleitungen 21 von der Strahlführung 9 zu den Belichtungsmaschinen 2 im Reinraum 13 sind im Unterschied zu den vorigen Ausführungsbeispielen länger, da sie sich nicht nur durch das Fundament 12, sondern auch durch die beiden Untergeschosse 18, 20 erstrecken. Die Zuleitungen 21 schließen wiederum an die Strahlführung 9 an. Die Böden 10, 19 des Reinraums 13 sowie des Untergeschosses 18 sind mit entsprechenden Durchführungsöffnungen für die Zuleitungen 21 versehen.

Da die Strahlführung 9 unterhalb der Bodenplatte 12 liegt, kann sie optimal so positioniert werden, dass die Zuleitungen 21 optimal zu den Maschinen 2 geführt werden können.

Anhand der Fig. 7 bis 9 wird die Durchführung der Zuleitungen 21 durch den Boden 10 des Reinraumes 13 näher beschrieben. Der Boden 10 wird durch Waffelelemente 22 gebildet, die im Rastermaß verlegt sind. Eine typische Abmessung des Waffelelementes 22 beträgt 7,2 m x 7,2 m x 1 m. Vorteilhaft besteht jedes Waffelelement 22 aus drei Abschnitten 22a, 22b, 22c. Diese Abschnitte haben vorteilhaft gleiche Abmessungen. Beispielhaft haben diese Abschnitte jeweils eine Länge von 7,2 m, eine Breite von 2,4 m und eine Höhe von 1 m.

Fig. 7 zeigt in Draufsicht den Boden 10, der aus den Waffelelementen 22 zusammengesetzt ist. Im Ausführungsbeispiel wird jedes Waffelelement 22 durch drei gleich große Abschnitte 22a bis 22c gebildet. Wie aus Fig. 7 hervorgeht, können die Waffelelementabschnitte innerhalb des Waffelelementes 22 gleich ausgebildet sein. Dies ist beispielhaft in den beiden Längsreihen 23 und 24 des Bodens 10 der Fall. In der mittleren Reihe 25 des Bodens 10 sind Waffelelemente 22 vorgesehen, deren Abschnitte gleich, aber auch unterschiedlich gestaltet sind.

Grundsätzlich ist es auch möglich, dass das Waffelelement 22 aus nur einem Abschnitt besteht.

Das Waffelelement 22 gemäß Fig. 8 wird im Boden 10 des Reinraumes dort eingesetzt, wo die Zuleitungen 21 zu den Maschinen 2 hindurchtreten. Das Waffelelement 22 hat die beiden gleich ausgebildeten Abschnitte 22a, 22c, die mit Durchtrittsöffnungen 26 versehen sind. Sie sind vorteilhaft in Reihen neben- und hintereinander angeordnet. Die im Reinraum 13 von oben nach unten strömende Reinluft tritt durch diese Öffnungen 26 nach unten aus dem Reinraum 13 aus. Die Durchtrittsöffnungen 26 haben vorteilhaft kreisförmigen Umriss.

Der mittlere Abschnitt 22b des Waffelelementes 22 ist mit Durchlässen 27 für die Zuleitungen 21 versehen. Die Durchlässe 27 liegen mit Abständen nebeneinander. Sie sind gleich ausgebildet und haben jeweils rechteckigen Umriss. Im dargestellten Ausführungsbeispiel sind die Durchlässe 27 so angeordnet, dass ihre Längsachsen 28 unter einem spitzen Winkel α zur Längsachse 29 des Abschnittes 22b, liegen, in Draufsicht auf das Waffelelement 22 gesehen. Die Schräglage der Durchlässe 27 ist so vorgesehen, dass die Zuleitungen 21 in ihrer schrägen Lage bezüglich der Strahlführung 9 einwandfrei durch die Durchlässe 27 geführt werden können. Wie Fig. 9 zeigt, liegen die Zuleitungen 21 unter dem Winkel β zu der die Längsachse 29 enthaltenden Längsmittelebene 30 des Abschnittes 22b. In Fig. 8 ist durch gestrichelte Linien eine der Zuleitungen 21 dargestellt, die durch den einen Durchlass 27 verläuft. In Draufsicht auf das Waffelelement 22 gesehen verläuft die Zuleitung 21 parallel zu den Längsseiten des Durchlasses 27.

Die Durchlässe 27 haben eine solche Querschnittsform, dass die Reinluft auch durch die Durchlässe 27 an den Zuleitungen 21 vorbei nach unten strömen kann. Dabei ist der Querschnitt der Durchlässe 27 vorteilhaft so groß, dass in der Summe der im mittleren Abschnitt 22b liegenden Durchlässe die gleiche Luftmenge hindurchströmen kann wie durch die Durchtrittsöffnungen 26 in den Abschnitten 22a bzw. 22c.

Darüber hinaus ist das Waffelelement 22 so ausgebildet, dass die Steifigkeit des Waffelelementes 22 trotz der Durchlässe 27 die Anforderungen bezüglich der Schwingungsfestigkeit und der Tragfähigkeit erfüllt.

Die Zuleitungen 21, die ebenso wie die Strahlführung 9 Vakuumröhren sind, sind in geeigneter Weise am Waffelelement 22 so befestigt, dass keine Schwingungen vom Waffelelement 22 bzw. vom Boden 10 des Reinraumes 13 aus in die Zuleitungen 21 gelangen. Dadurch ist gewährleistet, dass die Belichtung auf den Maschinen 2 mit der geforderten Genauigkeit gewährleistet ist.

Wie aus Fig. 7 hervorgeht, sind die Durchlässe 27 im Boden 10 des Reinraums 13 nur an denjenigen Stellen vorgesehen, an denen die Zuleitungen 21 vom Untergeschoss 18 aus zugeführt werden.

Grundsätzlich besteht auch die Möglichkeit, die einzelnen Abschnitte 22a bis 22c als gesonderte Teile einzusetzen, wodurch die Variabilität bei der Erstellung des Reinraumbodens 10 erhöht wird. Dann können die mit den Durchlässen 27 für die Zuleitungen 21 versehenen Abschnitte 22b an jeder gewünschten Stelle innerhalb des Reinraumbodens 10 angeordnet werden.

Die Waffelelemente 22 bzw. ihre einzelnen Abschnitte sind in bekannter Weise so miteinander verbunden, dass die Reinluft nur durch die Durchtrittsöffnungen 26 sowie die Durchlässe 27 nach unten aus dem Reinraum 13 austreten kann.

## Patentansprüche

1. Waffelelement (22) für eine Fertigungsanlage, das wenigstens einen Durchlass (27) aufweist, wobei der Durchlass einen rechteckigen Umriss und das Waffelelement einen viereckigen Umriss hat, **dadurch gekennzeichnet, dass** eine Seite des rechteckigen Durchlasses mit einer Seite des viereckigen Waffelelementes, in Draufsicht auf das Waffelelement gesehen, einen spitzen Winkel (α) einschließt.

2. Waffelelement nach Anspruch 1, **dadurch gekennzeichnet, dass** der Durchlass (27) mittig im Waffelelement (22) vorgesehen ist.

3. Waffelelement nach Anspruch 1 oder 2, **dadurch gekennzeichnet, dass** das Waffelelement (22) wenigstens zwei nebeneinanderliegende Abschnitte (22a bis 22c) aufweist, von denen der eine Abschnitt (22b) den Durchlass (27) für eine Zuleitung (21) und der andere Abschnitt (22a, 22c) Durchtrittsöffnungen (26) für Reinluft aufweist.

4. Waffelelement nach Anspruch 3, **dadurch gekennzeichnet, dass** die Abschnitte (22a bis 22c) gleiche Umrissform und/oder gleiche Dicke haben.

5. Fertigungsanlage zur Herstellung von integrierten Schaltkreisen auf Halbleiter-Wafern, aufweisend:
- wenigstens einen Strahlungserzeuger
- wenigstens eine Strahlführung (9)
- wenigstens eine Lithografie-Maschine (2)
- ein Fabrikationsgebäude (1)
- einen Reinraum (13)
- ein vom Fabrikationsgebäude (1) getrenntes Gebäude (3) oder getrennter Gebäudeabschnitt
- wenigstens eine Zuleitung (21)
wobei der Strahlungserzeuger EUV- Strahlung erzeugt, die der Lithografie-Maschine (2) zur Belichtung der Wafer zugeführt wird, die in dem Fabrikationsgebäude (1) untergebracht ist, wobei der Strahlungserzeuger in dem vom Fabrikationsgebäude (1) getrennten Gebäude (3) oder Gebäudeabschnitt untergebracht ist, die EUV-Strahlung vom getrennten Gebäude (3) oder Gebäudeabschnitt aus über die Strahlführung (9) dem Fabrikationsgebäude (1) zugeführt wird und von der Strahlführung (9) im Bereich des Fabrikationsgebäudes (1) unter einem stumpfen Winkel die Zuleitung (21) abzweigt, über die wenigstens ein Teil der EUV-Strahlung der Lithografie-Maschine (2) zugeführt wird, wobei die Zuleitung (21) durch einen Durchlass (27) in einem durch Waffelelemente (22) gebildeten gelochten Boden (10) des Reinraumes (13) verläuft, wobei der Durchlass (27) rechteckigen Umriss hat und in einem Waffelelement nach Anspruch 1 angeordnet ist.

6. Anlage nach Anspruch 5,
**dadurch gekennzeichnet, dass** die Strahlführung (9) im Bereich der Lithografie-Maschine (2) im Fabrikationsgebäude (1) verläuft.

7. Anlage nach Anspruch 5 oder 6,
**dadurch gekennzeichnet, dass** die Strahlführung (9) unterhalb des Fundamentes (12) des Fabrikationsgebäudes (1) verläuft.

8. Anlage nach einem der Ansprüche 5 bis 7,
**dadurch gekennzeichnet, dass** die Strahlführung (9) in einem Geschoss (18, 20) unterhalb oder oberhalb des Reinraumes (13) verläuft.

9. Anlage nach einem der Ansprüche 5 bis 8,
**dadurch gekennzeichnet, dass** die Strahlführung (9) im Bereich eines Personalzuganges (5) an das Fabrikationsgebäude (1) herangeführt ist, und dass vorteilhaft ein Materialzugang (4) an der dem Personalzugang (5) gegenüberliegenden Seite des Fabrikationsgebäudes (1) vorgesehen ist.

10. Anlage nach einem der Ansprüche 5 bis 9,
**dadurch gekennzeichnet, dass** das Waffelelement (22) mehrere Durchlässe (27) für die Zuleitung (21) aufweist.

## Claims

1. Waffle element (22) for a production plant that comprises at least one opening (27) wherein the opening has a rectangular outline and the waffle element has a square outline,
**characterised in that** in a view from above onto the waffle element one side of the rectangular opening forms an acute angle (α) with one side of the square waffle element.

2. Waffle element according to claim 1,
**characterised in that** the opening (27) is provided centrally in the waffle element (22).

3. Waffle element according to claim 1 or 2,
**characterised in that** the waffle element (22) comprises at least two adjacent sections (22a to 22c) of which one section (22b) has the opening (27) for a supply line (21) and the other section (22a, 22c) has through openings (26) for clean air.

4. Waffle element according to claim 3,
**characterised in that** the sections (22a to 22c) have the same outline shape and/or the same thickness.

5. Poduction plant for producing integrated circuits on semiconductor wafers, comprising
- at least one radiation generator
- at least one beam guide (9)
- at least one lithography machine (2)
- a production building (1)
- a clean room (13)
- a building (3) separate from the production building (1) or separate part of the building,
- at least one supply line (21)
wherein the radiation generator generates EUV radiation which is supplied to the lithography machine (2) to expose the wafers which is accommodated in the production building (1), wherein the radiation generator in accommodated in the building (3) or building section separate from the production building (1), the EUV radiation is supplied from the separate building (3) or building section via the beam guide (9) to the production building (1), and in the area of the production building (1) the supply line (21) via which at least part of the EUV radiation is supplied to the lithography machine (2) branches off from the beam guide (9) at an obtuse angle, wherein the supply line (21) passes through an opening (27) in a perforated floor (10) formed by waffle elements (22) of the clean room (13), wherein the opening (27) has a rectangular outline and is arranged in a waffle element according to claim 1.

6. Plant according to claim 5,
**characterised in that** the beam guide (9) extends in the area of the lithography machine (2) in the production building (1).

7. Plant according to claim 5 or 6,
**characterised in that** the beam guide (9) extends below the foundation (12) of the production building (1) .

8. Plant according to any one of claims 5 to 7,
**characterised in that** the beam guide (9) extends in a storey of the building (18, 20) below or above the clean room (13).

9. Plant according to any one of claims 5 to 8,
**characterised in that** the beam guide (9) is guided towards the area of a personnel access point (5) to the production building (1) and that advantageously a material access point (4) is provided on the opposite side of the production building (1) from the personnel access point (5).

10. Plant according to any one of claims 5 to 9,
**characterised in that** the waffle element (22) has several openings (27) for the supply line (21).

## Revendications

1. Élément alvéolé (22) destiné à une installation de fabrication, qui comporte au moins un passage (27), le passage ayant un contour rectangulaire et l'élément alvéolé ayant un contour carré,
**caractérisé en ce que**, vu en élévation sur l'élément alvéolé, un côté du passage rectangulaire inclut avec un côté de l'élément alvéolé un angle aigu (α).

2. Élément alvéolé selon la revendication 1,
**caractérisé en ce que** le passage (27) est prévu au centre dans l'élément alvéolé (22).

3. Élément alvéolé selon la revendication 1 ou 2,
**caractérisé en ce que** l'élément alvéolé (22) comporte au moins deux parties (22a à 22c) placées côte à côte, dont l'une partie (22b) comporte le passage (27) pour un conduit d'alimentation (21) et l'autre partie (22a, 22c) comporte des orifices de passage (26) pour de l'air pur.

4. Élément alvéolé selon la revendication 3,
**caractérisé en ce que** les parties (22a à 22c) ont un contour de même forme et/ou sont de même épaisseur.

5. Installation de fabrication destinée à la fabrication de circuits imprimés sur des tranches de semi-conducteur, comportant :
- au moins un générateur de rayonnement
- au moins un guidage de faisceau (9)
- au moins une machine lithographique (2)
- un bâtiment de fabrication (1)
- une salle blanche (13)
- un bâtiment (3) séparé ou une partie de bâtiment séparée du bâtiment de fabrication (1)
- au moins un conduit d'alimentation (21)
le générateur de rayonnement générant un rayonnement EUV qui est amené vers la machine lithographique (2) pour irradier les tranches, qui sont disposées dans le bâtiment de fabrication (1), le générateur de rayonnement étant disposé dans le bâtiment (3) ou dans la partie de bâtiment séparé(e) du bâtiment de fabrication (1), le rayonnement EUV étant amené du bâtiment (3) ou de la partie de bâtiment séparé (e) via le guidage de faisceau (9) vers le bâtiment de fabrication (1) et dans la zone du bâtiment de fabrication (1), le conduit d'alimentation (21) via lequel au moins une partie du rayonnement EUV est amenée vers la machine lithographique (2) dérivant du guidage de faisceau (9) sous un angle obtus, le conduit d'alimentation (21) s'écoulant à travers un passage (27) dans un sol (10) perforé de la salle blanche (13) formé par des éléments alvéolés (22), le passage (27) ayant un contour rectangulaire et étant placé dans un élément alvéolé selon la revendication 1.

6. Installation selon la revendication 5,
**caractérisée en ce que** le guidage de faisceau (9) s'écoule dans la zone de la machine lithographique (2) dans le bâtiment de fabrication (1).

7. Installation selon la revendication 5 ou 6,
**caractérisée en ce que** le guidage de faisceau (9) s'écoule sous les fondations (12) du bâtiment de fabrication (1) .

8. Installation selon l'une quelconque des revendications 5 à 7,
**caractérisée en ce que** le guidage de faisceau (9) s'écoule dans un étage (18, 20) en-dessous ou au-dessus de la salle blanche (13).

9. Installation selon l'une quelconque des revendications 5 à 8,
**caractérisée en ce que** le guidage de faisceau (9) est tiré vers la zone d'un accès du personnel (5) au bâtiment de fabrication (1) et **en ce qu'**avantageusement, un accès de matériel (4) est prévu sur le côté du bâtiment de fabrication (1) qui est opposé à l'accès du personnel (5)

10. Installation selon l'une quelconque des revendications 5 à 9,
**caractérisée en ce que** l'élément alvéolé (22) comporte plusieurs passages (27) pour le conduit d'alimentation (21).
